(19) Europäisches Patentamt
European Patent Office
Office européen des brevets

(11) **EP 2 164 938 B1**

(12) **EUROPEAN PATENT SPECIFICATION**

(45) Date of publication and mention
of the grant of the patent:
**21.06.2017 Bulletin 2017/25**

(21) Application number: **08755687.4**

(22) Date of filing: **16.05.2008**

(51) Int Cl.:
*C11D 1/00* (2006.01)     *C11D 1/62* (2006.01)
*C11D 3/30* (2006.01)     *C09K 13/00* (2006.01)
*C23F 11/10* (2006.01)

(86) International application number:
**PCT/US2008/063885**

(87) International publication number:
**WO 2008/144501 (27.11.2008 Gazette 2008/48)**

(54) **NEW ANTIOXIDANTS FOR POST-CMP CLEANING FORMULATIONS**

NEUE ANTIOXIDANTIEN FÜR NACH CMP ZUM EINSATZ KOMMENDE REINIGUNGSMITTEL

NOUVEAUX ANTIOXYDANTS POUR FORMULATION DE NETTOYAGE POST-CMP

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **17.05.2007 US 938591 P**

(43) Date of publication of application:
**24.03.2010 Bulletin 2010/12**

(73) Proprietor: **ENTEGRIS INC.**
**Billerica, MA 01821 (US)**

(72) Inventors:
• **ZHANG, Peng**
**Montvale, New Jersey 07645 (US)**
• **BARNES, Jeffrey**
**Connecticut 06751 (US)**
• **SONTHALIA, Prerna**
**Mumbai 56 (IN)**

• **COOPER, Emanuel**
**Scarsdale, New York 10583 (US)**
• **BOGGS, Karl**
**Hopewell Junction, New York 12533 (US)**

(74) Representative: **ABG Patentes, S.L.**
**Avenida de Burgos, 16D**
**Edificio Euromor**
**28036 Madrid (ES)**

(56) References cited:
EP-A2- 1 612 611          WO-A1-2006/127885
WO-A2-2008/005354       WO-A2-2008/036823
US-A1- 2001 004 633      US-A1- 2003 096 500
US-A1- 2003 130 147      US-A1- 2005 284 844
US-A1- 2005 284 844      US-A1- 2006 019 201
US-A1- 2007 060 490      US-A1- 2008 004 197
US-B2- 6 599 370          US-B2- 6 599 370
US-B2- 6 992 050          US-B2- 6 992 050

**Description**

## FIELD

The present invention relates generally to compositions including antioxidants for cleaning residue and/or contaminants from microelectronic devices having same thereon.

## DESCRIPTION OF THE RELATED ART

Microelectronic device wafers are used to form integrated circuits. The microelectronic device wafer includes a substrate, such as silicon, into which regions are patterned for deposition of different materials having insulative, conductive or semi-conductive properties.

In order to obtain the correct patterning, excess material used in forming the layers on the substrate must be removed. Further, to fabricate functional and reliable circuitry, it is important to prepare a flat or planar microelectronic wafer surface prior to subsequent processing. Thus, it is necessary to remove and/or polish certain surfaces of a microelectronic device wafer.

Chemical Mechanical Polishing or Planarization ("CMP") is a process in which material is removed from a surface of a microelectronic device wafer, and the surface is polished (more specifically, planarized) by coupling a physical process such as abrasion with a chemical process such as oxidation or chelation. In its most rudimentary form, CMP involves applying slurry, e.g., a solution of an abrasive and an active chemistry, to a polishing pad that buffs the surface of a microelectronic device wafer to achieve the removal, planarization, and polishing processes. It is not desirable for the removal or polishing process to be comprised of purely physical or purely chemical action, but rather the synergistic combination of both in order to achieve fast, uniform removal. In the fabrication of integrated circuits, the CMP slurry should also be able to preferentially remove films that comprise complex layers of metals and other materials so that highly planar surfaces can be produced for subsequent photolithography, or patterning, etching and thin-film processing.

Recently, copper has been increasingly used for metal interconnects in integrated circuits. In copper damascene processes commonly used for metallization of circuitry in microelectronic device fabrication, the layers that must be removed and planarized include copper layers having a thickness of about 1-1.5 $\mu$m and copper seed layers having a thickness of about 0.05-0.15 $\mu$m. These copper layers are separated from the dielectric material surface by a layer of barrier material, typically about 50-300 Å thick, which prevents diffusion of copper into the oxide dielectric material. One key to obtaining good uniformity across the wafer surface after polishing is to use a CMP slurry that has the correct removal selectivities for each material.

The foregoing processing operations, involving wafer substrate surface preparation, deposition, plating, etching and chemical mechanical polishing, variously require cleaning operations to ensure that the microelectronic device product is free of contaminants that would otherwise deleteriously affect the function of the product, or even render it useless for its intended function. Often, particles of these contaminants are smaller than 0.3 $\mu$m.

One particular issue in this respect is the residues that are left on the microelectronic device substrate following CMP processing. Such residues include CMP material and corrosion inhibitor compounds such as benzotriazole (BTA). If not removed, these residues can cause damage to copper lines or severely roughen the copper metallization, as well as cause poor adhesion of post-CMP applied layers on the device substrate. Severe roughening of copper metallization is particularly problematic, since overly rough copper can cause poor electrical performance of the product microelectronic device.

Another residue-producing process common to microelectronic device manufacturing involves gas-phase plasma etching to transfer the patterns of developed photoresist coatings to the underlying layers, which may consist of hardmask, interlevel dielectric (ILD), and etch stop layers. Post-gas phase plasma etch residues, which may include chemical elements present on the substrate and in the plasma gases, are typically deposited on the back end of the line (BEOL) structures and if not removed, may interfere with subsequent silicidation or contact formation. Conventional cleaning chemistries often damage the ILD, absorb into the pores of the ILD thereby increasing the dielectric constant, and/or corrode the metal structures.

The microelectronics industry therefore continues to seek improvement in cleaning formulations for copper-metallized substrates, and in compositions for processing of microelectronic device structures, including compositions variously useful for post-etching cleaning, post-ashing cleaning and post-chemical mechanical polishing cleaning of microelectronic device wafers.

Cleaning formulations have been described in the prior art. US 6,992,050 B2 discloses a resist and post-etch residue stripping composition comprising an anticorrosive agent, a stripping agent (either an alkanolamine or a hydrofluoric acid salt) and a solvent, wherein the anticorrosive agent is a heterocyclic compound having a nitrogen atom-containing six-membered ring. US 2001/004633, relates to a post-CMP cleaning solution comprising a quaternary ammonium hydroxide, an organic amine, a corrosion inhibitor, optionally an organic acid, and water. WO 2006/127885 A1 discloses a post-CMP cleaning composition, comprising at least one amine, at least one passivating agent, optionally at least one quaternary base, optionally at least one reducing agent, and water. US 2005/284844 A1 relates to a cleaning composition for semiconductor components comprises a water-soluble polymer (a) having a specific molecular weight and a compound (b) represented by the following formula (1): $NR_4OH$, wherein each R is independently a hydrogen atom or an alkyl group of 1 to 6 carbon atoms.

SUMMARY

The present invention generally relates to a composition and process for cleaning residue and/or contaminants from microelectronic devices having said residue and contaminants thereon. The cleaning compositions of the invention include one novel antioxidant as a corrosion inhibitor. The residue may include post-CMP, post-etch, or post-ash residue.

In one aspect, a cleaning composition as defined in claim 1 presently on file.

In another aspect, a cleaning composition as defined in claim 1 presently on file wherein the cleaning composition is effective for the removal of residue from a microelectronic device having said residue thereon.

In another aspect, the invention relates to a kit comprising, in one or more containers, one or more of the following reagents for forming a cleaning composition, said one or more reagents selected from the group consisting of: at least one corrosion inhibitor; at least one quaternary base; at least one organic amine; and combinations thereof. The at least one corrosion inhibitor is as defined in claim 1 presently on file.

In yet another aspect, a method of removing residue and contaminants from a microelectronic device having said residue and contaminants thereon is described, said method comprising contacting the microelectronic device with a cleaning composition for sufficient time to at least partially clean said residue and contaminants from the microelectronic device, wherein the cleaning composition is as defined in claim 1 presently on file.

In another aspect, a method of removing post-CMP residue and contaminants from a microelectronic device having same thereon is described, said method comprising:

polishing the microelectronic device with a CMP slurry;
contacting the microelectronic device with a cleaning composition as defined in claim 1 presently on file for a sufficient time to remove post-CMP residue and contaminants from the microelectronic device to form a post-CMP residue-containing composition; and
continuously contacting the microelectronic device with the post-CMP residue-containing composition for a sufficient amount of time to effect substantial cleaning of the microelectronic device.

In a further aspect, a method of manufacturing a microelectronic device is described, said method comprising contacting the microelectronic device with a cleaning composition as defined in claim 1 presently on file for sufficient time to at least partially clean post-CMP residue, post-etch residue, post-ash residue and/or contaminants from the microelectronic device having said residue and contaminants thereon.

Yet another aspect relates to improved microelectronic devices, and products incorporating same, made using the methods described herein comprising cleaning of post-CMP residue, post-etch residue, post-ash residue and/or contaminants from the microelectronic device having said residue and contaminants thereon, using the methods and/or compositions described herein, and optionally, incorporating the microelectronic device into a product.

Another aspect relates to an article of manufacture comprising a cleaning composition, a microelectronic device wafer, and material selected from the group consisting of residue, contaminants and combinations thereof, wherein the cleaning composition is as defined in claim 1 presently on file, and wherein the residue comprises at least one of post-CMP residue, post-etch residue and post-ash residue.

Other aspects, features and advantages of the invention will be more fully apparent from the ensuing disclosure and appended claims.

**DETAILED DESCRIPTION OF THE INVENTION, AND PREFERRED EMBODIMENTS THEREOF**

The present invention relates generally to compositions useful for the removal of residue and contaminants from a microelectronic device having such material(s) thereon. The compositions are particularly useful for the removal of post-CMP, post-etch or post-ash residue.

For ease of reference, "microelectronic device" corresponds to semiconductor substrates, flat panel displays, phase change memory devices, solar panels and other products including solar substrates, photovoltaics, and microelectromechanical systems (MEMS), manufactured for use in microelectronic, integrated circuit, or computer chip applications. Solar substrates include, but are not limited to, silicon, amorphous silicon, polycrystalline silicon, monocrystalline silicon,

CdTe, copper indium selenide, copper indium sulfide, and gallium arsenide on gallium. The solar substrates may be doped or undoped. It is to be understood that the term "microelectronic device" is not meant to be limiting in any way and includes any substrate that will eventually become a microelectronic device or microelectronic assembly.

As used herein, "residue" corresponds to particles generated during the manufacture of a microelectronic device including, but not limited to, plasma etching, ashing, chemical mechanical polishing, wet etching, and combinations thereof.

As used herein, "contaminants" correspond to chemicals present in the CMP slurry, reaction by-products of the polishing slurry, chemicals present in the wet etching composition, reaction by products of the wet etching composition, and any other materials that are the by-products of the CMP process, the wet etching, the plasma etching or the plasma ashing process.

As used herein, "post-CMP residue" corresponds to particles from the polishing slurry, e.g., silica-containing particles, chemicals present in the slurry, reaction by-products of the polishing slurry, carbon-rich particles, polishing pad particles, brush deloading particles, equipment materials of construction particles, copper, copper oxides, organic residues, and any other materials that are the by-products of the CMP process.

As defined herein, "low-k dielectric material" corresponds to any material used as a dielectric material in a layered microelectronic device, wherein the material has a dielectric constant less than about 3.5. Preferably, the low-k dielectric materials include low-polarity materials such as silicon-containing organic polymers, silicon-containing hybrid organic/inorganic materials, organosilicate glass (OSG), TEOS, fluorinated silicate glass (FSG), silicon dioxide, and carbon-doped oxide (CDO) glass. It is to be appreciated that the low-k dielectric materials may have varying densities and varying porosities.

As defined herein, the term "barrier material" corresponds to any material used in the art to seal the metal lines, e.g., copper interconnects, to minimize the diffusion of said metal, e.g., copper, into the dielectric material. Preferred barrier layer materials include tantalum, titanium, ruthenium, hafnium, tungsten, and other refractory metals and their nitrides and silicides.

As defined herein, "post-etch residue" corresponds to material remaining following gas-phase plasma etching processes, e.g., BEOL dual damascene processing, or wet etching processes. The post-etch residue may be organic, organometallic, organosilicic, or inorganic in nature, for example, silicon-containing material, carbon-based organic material, and etch gas residue such as oxygen and fluorine.

As defined herein, "post-ash residue," as used herein, corresponds to material remaining following oxidative or reductive plasma ashing to remove hardened photoresist and/or bottom anti-reflective coating (BARC) materials. The post-ash residue may be organic, organometallic, organosilicic, or inorganic in nature.

"Substantially devoid" is defined herein as less than 2 wt. %, preferably less than 1 wt. %, more preferably less than 0.5 wt. %, and most preferably less than 0.1 wt. %.

As used herein, "about" is intended to correspond to ± 5 % of the stated value.

As used herein, "suitability" for cleaning residue and contaminants from a microelectronic device having said residue and contaminants thereon corresponds to at least partial removal of said residue/contaminants from the microelectronic device. Cleaning efficacy is rated by the reduction of objects on the microelectronic device. For example, pre- and post-cleaning analysis may be carried out using an atomic force microscope. The particles on the sample may be registered as a range of pixels. A histogram (e.g., a Sigma Scan Pro) may be applied to filter the pixels in a certain intensity, e.g., 231-235, and the number of particles counted. The particle reduction may be calculated using:

$$\text{Cleaning Efficacy} = \frac{(\text{Number of PreClean Objects - Number of PostClean Objects})}{\text{Number of PreClean Objects}} \times 100$$

Notably, the method of determination of cleaning efficacy is provided for example only and is not intended to be limited to same. Alternatively, the cleaning efficacy may be considered as a percentage of the total surface that is covered by particulate matter. For example, AFM's may be programmed to perform a z-plane scan to identify topographic areas of interest above a certain height threshold and then calculate the area of the total surface covered by said areas of interest. One skilled in the art would readily understand that the less area covered by said areas of interest post-cleaning, the more efficacious the cleaning composition. Preferably, at least 75% of the residue/contaminants are removed from the microelectronic device using the compositions described herein, more preferably at least 90%, even more preferably at least 95%, and most preferably at least 99% of the residue/contaminants are removed.

Compositions described herein may be embodied in a wide variety of specific formulations, as hereinafter more fully described.

In all such compositions, wherein specific components of the composition are discussed in reference to weight percentage ranges including a zero lower limit, it will be understood that such components may be present or absent in various specific embodiments of the composition, and that in instances where such components are present, they may be present at concentrations as low as 0.001 weight percent, based on the total weight of the composition in which such components are employed.

The antioxidant component is added to the cleaning composition to lower the corrosion rate of metals, e.g., copper, aluminum, as well as enhance the cleaning performance. Antioxidants (i.e., corrosion inhibitors) contemplated are glucuronic acid; squaric acid; adenosine and derivatives thereof; phenanthroline/ascorbic acid; flavonoids such as flavonols and anthocyanins and derivatives thereof; flavonol/anthocyanin; and combinations thereof. For example, the flavonols may include quercitin and derivatives thereof such as quercetin glucosides, quercitrin (quercetinrhamnoside) and rutin (quercetin rutinoside). The combination of anthocyanins and flavonols increases the solubility of flavonols in water. Particularly preferred antioxidants include squaric acid, adenosine and derivatives thereof, phenanthroline/ascorbic acid, flavonoids, anthocyanins, flavonol/anthocyanins, quercitin and derivatives thereof, and glucuronic acid.

The solvent comprises water, preferably deionized water.

In a further aspect the cleaning composition comprises a composition (i)-(ii), wherein the antioxidant (i.e., corrosion inhibitor) is is as defined in claim 1 presently on file,

- (i) a composition comprising at least one quaternary base, at least one organic amine, at least one antioxidants and water.

In a particularly preferred embodiment, the cleaning composition comprises at least one quaternary base, at least one organic amine, at least one antioxidant, and water, wherein the antioxidant (i.e., corrosion inhibitor) is selected from the group consisting of glucuronic acid; squaric acid; adenosine and derivatives thereof; phenanthroline/ascorbic acid; flavonoids such as flavonols and anthocyanins and derivatives thereof; flavonol/anthocyanin; and combinations thereof.

The cleaning composition is particularly useful for cleaning residue and contaminants, e.g., post-CMP residue, post-etch residue, post-ash residue, and contaminants from a microelectronic device structure. Regardless of the embodiment, the cleaning compositions are preferably substantially devoid of oxidizing agent, fluoride source, and abrasive material prior to removal of residue material from the microelectronic device. Importantly, when the cleaning composition includes glucoronic acid, the pH of the composition should be greater than or equal to 6.

In a further aspect of the invention, the cleaning composition may comprise, consist of, or consist essentially of a cleaning composition consisting of (i)-(ii), wherein the at least one antioxidant (i.e., corrosion inhibitor) is as defined in claim1 presently on file.

Illustrative amines that may be useful in specific compositions include species having the general formula $NR^1R^2R^3$, wherein $R^1$, $R^2$ and $R^3$ may be the same as or different from one another and are selected from the group consisting of hydrogen, straight-chained or branched $C_1$-$C_6$ alkyl (e.g., methyl, ethyl, propyl, butyl, pentyl, and hexyl) and straight-chained or branched $C_1$-$C_6$ alcohol (e.g., methanol, ethanol, propanol, butanol, pentanol, and hexanol). Most preferably, at least one of $R^1$, $R^2$ and $R^3$ is a straight-chained or branched $C_1$-$C_6$ alcohol. Examples include, without limitation, aminoethylethanolamine, N-methylaminoethanol, aminoethoxyethanol, dimethylaminoethoxyethanol, diethanolamine, N-methyldiethanolamine, monoethanolamine, triethanolamine, 1-amino-2-propanol, 2-amino-1-butanol, isobutanolamine, triethylenediamine, other $C_1$ - $C_8$ alkanolamines and combinations thereof.

Quaternary bases contemplated herein include compounds having the formula $NR^1R^2R^3R^4OH$, wherein $R^1$, $R^2$, $R^3$ and $R^4$ may be the same as or different from one another and are selected from the group consisting of hydrogen, straight-chained or branched $C_1$-$C_6$ alkyl (e.g., methyl, ethyl, propyl, butyl, pentyl, and hexyl), and substituted or unsubstituted $C_6$-$C_{10}$ aryl, e.g., benzyl. Tetraalkylammonium hydroxides that are commercially available include tetraethylammonium hydroxide (TEAH), tetramethyammonium hydroxide (TMAH), tetrapropylammonium hydroxide (TPAH), tetrabutylammonium hydroxide (TBAH), tributylmethylammonium hydroxide (TBMAH), benzyltrimethylammonium hydroxide (BTMAH), and combinations thereof, may be used. Tetraalkylammonium hydroxides which are not commercially available may be prepared in a manner analogous to the published synthetic methods used to prepare TMAH, TEAH, TPAH, TBAH, TBMAH, and BTMAH, which are known to one ordinary of skill in the art. Another widely used quaternary ammonium base is choline hydroxide.

With regards to compositional amounts, the weight percent ratios of each component in each embodiment described herein is as follows:

embodiment (i): about 0.1:1 to about 10:1 quaternary base to corrosion inhibitor, preferably about 0.5:1 to about 5:1, and even more preferably about 1:1 to about 2:1; about 0.1:1 to about 10:1 organic amine to corrosion inhibitor, preferably about 0.5:1 to about 5:1, and even more preferably about 2:1 to about 3:1;

.

The range of weight percent ratios of the components will cover all possible concentrated or diluted embodiments of the composition. Towards that end, in one embodiment, a concentrated cleaning composition is provided that can be diluted for use as a cleaning solution. A concentrated composition, or "concentrate," advantageously permits a user, e.g. CMP process engineer, to dilute the concentrate to the desired strength and pH at the point of use. Dilution of the concentrated cleaning composition may be in a range from about 1:1 to about 2500:1, preferably about 5:1 to about 200:1, wherein the cleaning composition is diluted at or just before the tool with solvent, e.g., deionized water. It is to be appreciated by one skilled in the art that following dilution, the range of weight percent ratios of the components disclosed herein should remain unchanged.

The compositions described herein may have utility in applications including, but not limited to, post-etch residue removal, post-ash residue removal surface preparation, post-plating cleaning and post-CMP residue removal.

In yet another preferred embodiment, the cleaning compositions described herein further include residue and/or contaminants. Importantly, the residue and contaminants may be dissolved and/or suspended in the compositions. Preferably, the residue includes post-CMP residue, post-etch residue, post-ash residue, contaminants, or combinations thereof.

The cleaning compositions are easily formulated by simple addition of the respective ingredients and mixing to homogeneous condition. Furthermore, the compositions may be readily formulated as single-package formulations or multi-part formulations that are mixed at or before the point of use, e.g., the individual parts of the multi-part formulation may be mixed at the tool or in a storage tank upstream of the tool. The concentrations of the respective ingredients may be widely varied in specific multiples of the composition, i.e., more dilute or more concentrated, in the broad practice of the invention, and it will be appreciated that the compositions of the invention can variously and alternatively comprise, consist or consist essentially of any combination of ingredients consistent with the disclosure herein.

Accordingly, another aspect relates to a kit including, in one or more containers, the components adapted to form the compositions as defined in claim 1. The containers of the kit must be suitable for storing and shipping said removal compositions, for example, NOWPak® containers (Advanced Technology Materials, Inc., Danbury, Conn., USA). The one or more containers which contain the components of the removal composition preferably include means for bringing the components in said one or more containers in fluid communication for blending and dispense. For example, referring to the NOWPak® containers, gas pressure may be applied to the outside of a liner in said one or more containers to cause at least a portion of the contents of the liner to be discharged and hence enable fluid communication for blending and dispense. Alternatively, gas pressure may be applied to the head space of a conventional pressurizable container or a pump may be used to enable fluid communication. In addition, the system preferably includes a dispensing port for dispensing the blended removal composition to a process tool.

Substantially chemically inert, impurity-free, flexible and resilient polymeric film materials, such as high density polyethylene, are preferably used to fabricate the liners for said one or more containers. Desirable liner materials are processed without requiring co-extrusion or barrier layers, and without any pigments, UV inhibitors, or processing agents that may adversely affect the purity requirements for components to be disposed in the liner. A listing of desirable liner materials include films comprising virgin (additive-free) polyethylene, virgin polytetrafluoroethylene (PTFE), polypropylene, polyurethane, polyvinylidene chloride, polyvinylchloride, polyacetal, polystyrene, polyacrylonitrile, polybutylene, and so on. Preferred thicknesses of such liner materials are in a range from about 5 mils (0.005 inch) to about 30 mils (0.030 inch), as for example a thickness of 20 mils (0.020 inch).

Regarding the containers for the kits of the invention, the disclosures of the following patents and patent applications are hereby incorporated herein by reference in their respective entireties: U.S. Patent No. 7,188,644 entitled "APPARATUS AND METHOD FOR MINIMIZING THE GENERATION OF PARTICLES IN ULTRAPURE LIQUIDS;" U.S. Patent No. 6,698,619 entitled "RETURNABLE AND REUSABLE, BAG-IN-DRUM FLUID STORAGE AND DISPENSING CONTAINER SYSTEM;" U.S. Patent Application No. 60/916,966 entitled "SYSTEMS AND METHODS FOR MATERIAL BLENDING AND DISTRIBUTION" filed on May 9, 2007 in the name of John E.Q. Hughes, and PCT/US08/63276 entitled "SYSTEMS AND METHODS FOR MATERIAL BLENDING AND DISTRIBUTION" filed on May 9, 2008 in the name of Advanced Technology Materials, Inc.

As applied to microelectronic manufacturing operations, the cleaning compositions described herein are usefully employed to clean post-CMP residue and/or contaminants from the surface of the microelectronic device. Importantly, the cleaning compositions do not damage low-k dielectric materials or corrode metal interconnects on the device surface. Preferably the cleaning compositions remove at least 85 % of the residue present on the device prior to residue removal, more preferably at least 90 %, even more preferably at least 95 %, and most preferably at least 99%.

In post-CMP residue and contaminant cleaning application, the cleaning composition may be used with a large variety of conventional cleaning tools such as megasonics and brush scrubbing, including, but not limited to, Verteq single wafer megasonic Goldfinger, OnTrak systems DDS (double-sided scrubbers), SEZ or other single wafer spray rinse, Applied Materials Mirra-Mesa™ /Reflexion ™/Reflexion LK™, and Megasonic batch wet bench systems.

In use of the compositions described herein for cleaning post-CMP residue, post-etch residue, post-ash residue and/or contaminants from microelectronic devices having same thereon, the cleaning composition typically is contacted with the device for a time of from about 5 sec to about 10 minutes, preferably about 1 sec to 20 min, preferably about 15 sec to about 5 min at temperature in a range of from about 20°C to about 90°C, preferably about 20°C to about 50°C. Such contacting times and temperatures are illustrative, and any other suitable time and temperature conditions may be employed that are efficacious to at least partially clean the post-CMP residue/contaminants from the device, within the broad practice of the method. "At least partially clean" and "substantial removal" both correspond to at removal of at least 85 % of the residue present on the device prior to residue removal, more preferably at least 90 %, even more preferably at least 95 %, and most preferred at least 99 %

Following the achievement of the desired cleaning action, the cleaning composition may be readily removed from the device to which it has previously been applied, as may be desired and efficacious in a given end use application of the compositions described herein. Preferably, the rinse solution includes deionized water. Thereafter, the device may be dried using nitrogen or a spin-dry cycle.

Advantageously, some of the antioxidants introduced herein undergo visible color changes as they are consumed, which provides a way for the user to monitor the efficacy of the cleaning composition bath. Monitoring means include, but are not limited to, visual and spectrophotometric means. As defined herein, an "endpoint" corresponds to a range whereby the cleaning composition is no longer efficiently and productively removing the materials to be removed from the microelectronic device, e.g., post-CMP residue. The endpoint can be the result of many different factors including, but not limited to, a saturated (e.g., loaded) cleaning composition, and/or the exhaustion of one or more components of the cleaning composition.

Yet another aspect relates to the improved microelectronic devices made according to the methods of the invention and to products containing such microelectronic devices.

Another aspect relates to a recycled cleaning composition, wherein the cleaning composition may be recycled until residue and/or contaminant loading reaches the maximum amount the cleaning composition may accommodate, as readily determined by one skilled in the art.

A still further aspect relates to methods of manufacturing an article comprising a microelectronic device, said method comprising contacting the microelectronic device with a cleaning composition for sufficient time to clean post-CMP residue and contaminants from the microelectronic device having said residue and contaminants thereon, and incorporating said microelectronic device into said article, using a cleaning composition as defined in claim 1 presently on file.

The features and advantages are more fully shown by the illustrative examples discussed below.

### Example 1

Blanketed PVD copper wafers were immersed in solutions including a basic solution comprising TMAH, 1-amino-2-propanol, and different antioxidants and the corrosion rate of copper determined using a potentiostat where the PVD Cu is the working electrode, Pt mesh is the counter electrode, and an Ag/AgCl electrode is the reference electrode. The copper anodic corrosion rates were calculated at anodic voltage biases from 0.1 to 1.0 V versus open circuit potentials. The results are summarized in Table 1 below.

| Antioxidant | Solution | Corrosion rate/Å min$^{-1}$ |
|---|---|---|
| Control (TMAH + 1-amino-2-propanol) | | 12.28 15.03 |
| Ascorbic acid not encompassed by the invention | 12 mL of 3500 ppm ascorbic acid in 200 g basic solution | 2.72 |
| | 18 mL of 3500 ppm ascorbic acid in 200 g basic solution | 2.62 |
| | 24 mL of 3500 ppm ascorbic acid in 200 g basic solution | 2.99 |
| uric acid not encompassed by the invention | 22 mL of 3500 ppm uric acid in 300 g basic solution | 17.47 |
| | 22 mL of 3500 ppm uric acid in 300 g basic solution | 13.43 |
| | 25 mL of 35000 ppm uric acid in 300 g basic solution | 7.57 |
| Uric acid + oxalic acid not encompassed by the invention | 25 mL of 35000 ppm uric (2% oxalic in 300 g basic solution) | 6.94 |
| | 25 mL of 35000 ppm uric (2% oxalic in 300 g basic solution) | 6.18 |

(continued)

| Antioxidant | Solution | Corrosion rate/Å min⁻¹ |
|---|---|---|
| succinic acid not encompassed by the invention | 25 mL of 3500 ppm succinic acid in 300 g basic solution | 15.05 |
| | 25 mL of 3500 ppm succinic acid in 300 g basic solution | 20.49 |
| adenosine | 800 ppm adenosine in the basic solution | 2.36 |
| | 800 ppm adenosine in the basic solution | 2.40 |
| | 800 ppm adenosine + 800 ppm ascorbic acid in the basic solution not encompassed by the invention | 3.18 |
| butylated hydroxytoluene not encompassed by the invention | 3.38 wt.% in the basic solution | 14.40 |
| methylene diphosphonic acid not encompassed by the invention | 3.62 wt.% in the basic solution | 16.80 |
| 2-amino-ethyl- not encompassed by the invention phosphonic acid not encompassed by the invention | 2.6 wt.% in the basic solution | 21.50 |

It can be seen that adenosine significantly reduced the corrosion rate of copper. Additional advantages include, but are not limited to, minimization of copper roughness and the stabilization of the copper (I) oxide surface subsequent to residue removal.

**Claims**

1. A cleaning composition consisting of water, at least one corrosion inhibitor, at least one quaternary base, and at least one organic amine, wherein the corrosion inhibitor consists of a species selected from the group consisting of: glucuronic acid; squaric acid; adenosine and derivatives thereof; phenanthroline in combination with ascorbic acid; flavonols and derivatives thereof; anthocyanins and derivatives thereof; flavonols in combination with anthocyanins; quercitin and derivatives thereof; quercitin in combination with anthocyanins; and combinations thereof, wherein the cleaning composition is effective for the removal of residue from a microelectronic device having said residue thereon.

2. The cleaning composition of claim 1, wherein the corrosion inhibitor consists of at least one species selected from the group consisting of squaric acid, adenosine and derivatives thereof, phenanthroline in combination with ascorbic acid, flavonoids, anthocyanins, flavonols in combination with anthocyanins, quercitin and derivatives thereof, glucuronic acid, quercitin in combination with anthocyanins, and combinations thereof.

3. The cleaning composition of claim 1, wherein the corrosion inhibitor consists of adenosine and derivatives thereof.

4. The cleaning composition of any of claims 1 to 3, wherein the at least one organic amine comprises a species selected from the group consisting of aminoethylethanolamine, N-methylaminoethanol, aminoethoxyethanol, dimethylaminoethoxyethanol, diethanolamine, N-methyldiethanolamine, monoethanolamine, triethanolamine, 1-amino-2-propanol, 2-amino-1-butanol, isobutanolamine, triethylenediamine, other $C_1$ - $C_8$ alkanolamines and combinations thereof.

5. The cleaning composition of any of claims 1 to 3, wherein the at least one quaternary base comprises a species selected from the group consisting of tetraethylammonium hydroxide, tetramethylammonium hydroxide, tetrapropylammonium hydroxide, tetrabutylammonium hydroxide, tributylmethylammonium hydroxide, benzyltrimethylammonium hydroxide, and combinations thereof.

6. The cleaning composition of any of claims 1, 2 or 3, wherein the residue consists of post-CMP residue, post-etch residue, post-ash residue, or combinations thereof.

7.  The cleaning composition of any of claims 1, 2 or 3, wherein the composition is substantially devoid of oxidizing agent, fluoride source, and/or abrasive material prior to removal of residue material from the microelectronic device.

8.  The cleaning composition of any of claims 1 to 3, wherein the composition is diluted in a range from 5:1 to 200:1.

9.  The cleaning composition of any of claims 1, 2 or 3, wherein the at least one amine has the general formula $NR^1R^2R^3$, where $R^1$, $R^2$ and $R^3$ may be the same as or different from one another and are selected from the group consisting of hydrogen, straight-chained $C_1$-$C_6$ alkyl, branched $C_1$-$C_6$ alkyl, straight-chained $C_1$-$C_6$ alcohol, and branched $C_1$-$C_6$ alcohol;

10.  The cleaning composition of any of claims 1 to 3, wherein the at least one quaternary base has the formula $NR^1R^2R^3R^4OH$, wherein $R^1$, $R^2$, $R^3$ and $R^4$ may be the same as or different from one another and are selected from the group consisting of hydrogen, straight-chained $C_1$-$C_6$ alkyl, branched $C_1$-$C_6$ alkyl, substituted $C_6$-$C_{10}$ aryl, and unsubstituted $C_6$-$C_{10}$ aryl;

11.  A method of removing residue and contaminants from a microelectronic device having said residue and contaminants thereon, said method comprising contacting the microelectronic device with a cleaning composition for sufficient time to at least partially clean said residue and contaminants from the microelectronic device, wherein the cleaning composition consists of water, at least one corrosion inhibitor, at least one quaternary base, and at least one organic amine, wherein the corrosion inhibitor consists of a species selected from the group consisting of glucuronic acid; squaric acid; adenosine and derivatives thereof; phenanthroline in combination with ascorbic acid; flavonols and derivatives thereof; anthocyanins and derivatives thereof; flavonols in combination with anthocyanins; quercitin and derivative thereof; quercitin in combination with anthocyanins; and combinations thereof.

12.  The method of claim 11, wherein the corrosion inhibitor comprises at least one species selected from the group consisting of squaric acid, adenosine and derivatives thereof, phenanthroline in combination with ascorbic acid, flavonoids, anthocyanins, flavonols in combination with anthocyanins, quercitin and derivatives thereof, glucuronic acid, quercitin in combination with anthocyanins, and combinations thereof.

13.  The method of claim 11, wherein the wherein the corrosion inhibitor consists of adenosine and derivatives thereof.

14.  The method of claim 11, further comprising diluting the cleaning composition with solvent at or before a point of use, wherein the solvent comprises water and wherein the composition is diluted in a range from 5:1 to 200:1.

15.  The method of claim 11, wherein the residue is post-CMP residue.

**Patentansprüche**

1.  Reinigungszusammensetzung bestehend aus Wasser, mindestens einem Korrosionsinhibitor, mindestens einer quaternären Base, und mindestens einem organischen Amin, wobei der Korrosionsinhibitor aus einer Spezies besteht, ausgewählt aus der Gruppe bestehend aus: Glucuronsäure; Quadratsäure; Adenosin und Derivaten desselben; Phenanthrolin in Kombination mit Ascorbinsäure; Flavonolen und Derivaten derselben; Anthocyanen und Derivaten derselben; Flavonolen in Kombination mit Anthocyanen; Quercetin und Derivaten desselben; Quercetin in Kombination mit Anthocyanen; und Kombinationen derselben, wobei die Reinigungszusammensetzung wirksam für die Beseitigung eines Rückstands aus einer mikroelektronischen Vorrichtung ist, welche den genannten Rückstand darauf aufweist.

2.  Reinigungszusammensetzung nach Anspruch 1, wobei der Korrosionsinhibitor aus mindestens einer Spezies besteht, ausgewählt aus der Gruppe bestehend aus Quadratsäure, Adenosin und Derivaten desselben, Phenanthrolin in Kombination mit Ascorbinsäure, Flavonoiden, Anthocyanen, Flavonolen in Kombination mit Anthocyanen, Quercetin und Derivaten desselben, Glucuronsäure, Quercetin in Kombination mit Anthocyanen, und Kombinationen derselben.

3.  Reinigungszusammensetzung nach Anspruch 1, wobei der Korrosionsinhibitor aus Adenosin und Derivaten desselben besteht.

**4.** Reinigungszusammensetzung nach einem der Ansprüche 1 bis 3, wobei das mindestens eine organische Amin eine Spezies umfasst, ausgewählt aus der Gruppe bestehend aus Aminoethylethanolamin, N-Methylaminoethanol, Aminoethoxyethanol, Dimethylaminoethoxyethanol, Diethanolamin, N-Methyldiethanolamin, Monoethanolamin, Triethanolamin, 1-Amino-2-propanol, 2-Amino-1-butanol, Isobutanolamin, Triethylendiamin, anderen $C_1$-$C_8$-Alkanolaminen und Kombinationen derselben.

**5.** Reinigungszusammensetzung nach einem der Ansprüche 1 bis 3, wobei die mindestens eine quaternäre Base eine Spezies umfasst, ausgewählt aus der Gruppe bestehend aus Tetraethylammoniumhydroxid, Tetramethylammoniumhydroxid, Tetrapropylammoniumhydroxid, Tetrabutylammoniumhydroxid, Tributylmethylammoniumhydroxid, Benzyltrimethylammoniumhydroxid, und Kombinationen derselben.

**6.** Reinigungszusammensetzung nach einem der Ansprüche 1, 2 oder 3, wobei der Rückstand aus einem Rückstand nach CMP, einem Rückstand nach Ätzung, einem Rückstand nach Veraschung, oder Kombinationen derselben besteht.

**7.** Reinigungszusammensetzung nach einem der Ansprüche 1, 2 oder 3, wobei die Zusammensetzung vor der Beseitigung des Rückstandsmaterials aus der mikroelektronischen Vorrichtung im Wesentlichen frei von Oxidationsmittel, Fluoridquelle und/oder Schleifstoff ist.

**8.** Reinigungszusammensetzung nach einem der Ansprüche 1 bis 3, wobei die Zusammensetzung in einem Bereich von 5:1 bis 200:1 verdünnt ist.

**9.** Reinigungszusammensetzung nach einem der Ansprüche 1, 2 oder 3, wobei das mindestens eine Amin die Allgemeinformel $NR^1R^2R^3$ aufweist, in welcher $R^1$, $R^2$ und $R^3$ gleich oder voneinander verschieden sein können und aus der Gruppe bestehend aus Wasserstoff, geradkettigem $C_1$-$C_6$-Alkyl, verzweigtem $C_1$-$C_6$-Alkyl, geradkettigem $C_1$-$C_6$-Alkohol, und verzweigtem $C_1$-$C_6$-Alkohol ausgewählt werden.

**10.** Reinigungszusammensetzung nach einem der Ansprüche 1 bis 3, wobei die mindestens eine quaternäre Base die Formel $NR^1R^2R^3R^4OH$ aufweist, wobei $R^1$, $R^2$, $R^3$ und $R^4$ gleich oder voneinander verschieden sein können und aus der Gruppe bestehend aus Wasserstoff, geradkettigem $C_1$-$C_6$-Alkyl, verzweigtem $C_1$-$C_6$-Alkyl, substituiertem $C_6$-$C_{10}$-Aryl und unsubstituiertem $C_6$-$C_{10}$-Aryl ausgewählt werden.

**11.** Verfahren zur Beseitigung von einem Rückstand und Verunreinigungen aus einer mikroelektronischen Vorrichtung, welche diesen Rückstand und diese Verunreinigungen darauf aufweist, wobei das genannte Verfahren das Inkontaktbringen der mikroelektronischen Vorrichtung mit einer Reinigungszusammensetzung für eine ausreichende Zeit um den genannten Rückstand und die genannten Verunreinigungen aus der mikroelektronischen Vorrichtung mindestens teilweise zu reinigen, umfasst, wobei die Reinigungszusammensetzung aus Wasser, mindestens einem Korrosionsinhibitor, mindestens einer quaternären Base und mindestens einem organischen Amin besteht, wobei der Korrosionsinhibitor aus einer Spezies besteht, ausgewählt aus der Gruppe bestehend aus Glucuronsäure; Quadratsäure; Adenosin und Derivaten desselben; Phenanthrolin in Kombination mit Ascorbinsäure; Flavonolen und Derivaten derselben; Anthocyanen und Derivaten derselben; Flavonolen in Kombination mit Anthocyanen; Quercetin und Derivaten desselben; Quercetin in Kombination mit Anthocyanen; und Kombinationen derselben.

**12.** Verfahren nach Anspruch 11, wobei der Korrosionsinhibitor mindestens eine Spezies umfasst, ausgewählt aus der Gruppe bestehend aus Quadratsäure, Adenosin und Derivaten desselben, Phenanthrolin in Kombination mit Ascorbinsäure, Flavonoiden, Anthocyanen, Flavonolen in Kombination mit Anthocyanen, Quercetin und Derivaten desselben, Glucuronsäure, Quercetin in Kombination mit Anthocyanen, und Kombinationen derselben.

**13.** Verfahren nach Anspruch 11, wobei der Korrosionsinhibitor aus Adenosin und Derivaten desselben besteht.

**14.** Verfahren nach Anspruch 11, zusätzlich umfassend das Verdünnen der Reinigungszusammensetzung mit einem Lösungsmittel an oder vor einem Verwendungszeitpunkt, wobei das Lösungsmittel Wasser umfasst und wobei die Zusammensetzung in einem Bereich von 5:1 bis 200:1 verdünnt wird.

**15.** Verfahren nach Anspruch 11, wobei der Rückstand ein Rückstand nach CMP ist.

**Revendications**

1. Composition de nettoyage composée d'eau, d'au moins un inhibiteur de corrosion, d'au moins une base quaternaire et d'au moins une amine organique, dans laquelle l'inhibiteur de corrosion est composé d'une espèce choisie parmi le groupe composé : de l'acide glucuronique, de l'acide squarique, de l'adénosine et des dérivés de celle-ci, de la phénanthroline en combinaison avec de l'acide ascorbique, des flavonols et des dérivés de ceux-ci, des anthocyanines et des dérivés de celles-ci, des flavonols en combinaison avec des anthocyanines, de la quercitine et des dérivés de celle-ci, de la quercitine en combinaison avec des anthocyanines et des combinaisons de ceux-ci, dans laquelle la composition de nettoyage est effective pour l'élimination de résidus d'un dispositif microélectronique ayant lesdits résidus sur lui.

2. Composition de nettoyant selon la revendication 1, dans laquelle l'inhibiteur de corrosion est composé d'au moins une espèce choisie parmi le groupe composé de l'acide squarique, de l'adénosine et des dérivés de celle-ci, de la phénanthroline en combinaison avec de l'acide ascorbique, des flavonoïdes, des anthocyanines, des flavonols en combinaison avec des anthocyanines, de la quercitine et des dérivés de celle-ci, de l'acide glucuronique, de la quercitine en combinaison aves des anthocyanines et des combinaisons de ceux-ci.

3. Composition de nettoyage selon la revendication 1, dans laquelle l'inhibiteur de corrosion est composé d'adénosine et des dérivés de celle-ci.

4. Composition de nettoyage selon l'une quelconque des revendications 1 ou 3, dans laquelle l'au moins une amine organique comprend une espèce choisie parmi le groupe composé de l'aminoéthyléthanolamine, du N-méthyaminoéthanol, de l'aminoéthoxyéthanol, du diméthylaminoéthoxyéthanol, de la diéthanolamine, de la N-méthyldiéthanolamine, de la monoéthanolamine, de la triéthanolamine, du 1-amino-2-propanol, du 2-amino-1-butanol, de l'isobutanolamine, de la triéthylènediamine, d'autres alkanolamines $C_1$-$C_8$ et des combinaisons de ceux-ci.

5. Composition de nettoyage selon l'une quelconque des revendications 1 à 3, dans laquelle l'au moins une base quaternaire comprend une espèce choisie parmi le groupe composé de l'hydroxyde de tétraéthylammonium, de l'hydroxyde de tétraméthylammonium, de l'hydroxyde de tétrapropylammonium, de l'hydroxyde de tétrabutylammonium, de l'hydroxyde de tributylméthylammonium, de l'hydroxyde de benzyltriméthylammonium et des combinaisons de ceux-ci.

6. Composition de nettoyage selon l'une quelconque des revendications 1, 2 ou 3, dans laquelle les résidus sont composés des résidus post-CMP, des résidus post-gravures, des résidus post-cendres, ou des combinaisons de ceux-ci.

7. Composition de nettoyage selon l'une quelconque des revendications 1, 2 ou 3, dans laquelle la composition est essentiellement dépourvue d'agent oxydant, de source de fluorure, et/ou de matière abrasive avant l'élimination de matière résiduelle du dispositif microélectronique.

8. Composition de nettoyage selon l'une quelconque des revendications 1 à 3, dans laquelle la composition est diluée dans un intervalle allant de 5:1 à 200:1.

9. Composition de nettoyage selon l'une quelconque des revendications 1, 2 ou 3, dans laquelle l'au moins une amine a la formule générale $NR^1R^2R^3$, dans laquelle $R^1$, $R^2$ et $R^3$ peuvent être identiques ou différents les uns des autres et sont choisis parmi le groupe composé de l'hydrogène, de l'alkyle $C_1$-$C_6$ à chaine droite, de l'alkyle $C_1$-$C_6$ ramifié, de l'alcool $C_1$-$C_6$ à chaîne droite et de l'alcool $C_1$-$C_6$ ramifié.

10. Composition de nettoyage selon l'une quelconque des revendications 1 à 3, dans laquelle l'au moins une base quaternaire a la formule $NR^1R^2R^3R^4OH$, dans laquelle $R^1$, $R^2$, $R^3$ et $R^4$ peuvent être identiques ou différents les uns des autres et ils sont choisis parmi le groupe composé de l'hydrogène, de l'alkyle $C_1$-$C_6$ à chaine droite, de l'alkyle $C_1$-$C_6$ ramifié, de l'aryle $C_6$-$C_{10}$ substitué et de l'aryle $C_6$-$C_{10}$ non substitué.

11. Procédé d'élimination de résidus et de contaminants d'un dispositif microélectronique ayant lesdits résidus et contaminants sur lui, ledit procédé comprenant la mise en contact du dispositif microélectronique avec une composition de nettoyage pendant un temps suffisant pour nettoyer au moins partiellement lesdits résidus et contaminants du dispositif microélectronique, dans lequel la composition de nettoyage est composée d'eau, d'au moins un inhibiteur de corrosion, d'au moins une base quaternaire et d'au moins une amine organique, dans lequel l'inhibiteur de corrosion est composé d'une espèce choisie parmi le groupe composé de l'acide glucuronique, de l'acide squarique, de l'adénosine et des dérivés de celle-ci, de la phénanthroline en combinaison avec de l'acide ascorbique, des flavonols et des dérivés de ceux-ci, des anthocyanines et des dérivés de celles-ci, des flavonols en combinaison avec des anthocyanines, de la quercitine et des dérivés de celle-ci, de la quercitine en combinaison avec des anthocyanines et des combinaisons de ceux-ci.

12. Procédé selon la revendication 11, dans lequel l'inhibiteur de corrosion comprend au moins une espèce choisie parmi le groupe composé de l'acide squarique, de l'adénosine et des dérivés de celle-ci, de la phénanthroline en combinaison avec de l'acide ascorbique, des flavonoïdes, des anthocyanines, des flavonols en combinaison avec des anthocyanines, de la quercitine et des dérivés de celle-ci, de l'acide glucuronique, de la quercitine en combinaison aves des anthocyanines et des combinaisons de ceux-ci.

13. Procédé selon la revendication 11, dans lequel l'inhibiteur de corrosion est composé de l'adénosine et des dérivés de celle-ci.

14. Procédé selon la revendication 11, comprenant en outre la dilution de la composition de nettoyage avec un solvant au ou avant le point d'utilisation, dans lequel le solvant comprend de l'eau et dans lequel la composition est diluée dans un intervalle allant de 5:1 à 200:1.

15. Procédé selon la revendication 11, dans lequel les résidus sont des résidus post-CMP.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6992050 B2
- US 2001004633 A
- WO 2006127885 A1
- US 2005284844 A1
- US 7188644 B
- US 6698619 B
- US 91696607 P
- US 0863276 W